# EUROPEAN PATENT APPLICATION

(11) **EP 0 871 223 A1**
(43) Date of publication of application: **14.10.1998**
(21) Application number: 96945365.3
(22) Date of filing: 30.12.1996
(51) Int. Cl.: H01L 27/02, H01L 21/82

(54) **PROCESS FOR THE PROTOTYPING OF MIXED SIGNAL APPLICATIONS AND FIELD PROGRAMMABLE SYSTEM ON A CHIP FOR APPLYING SAID PROCESS**

(30) Priority: 10.10.1996 ES 9602168
(71) Applicant: Semiconductores Investigaci n Y Diseno S.A. -(SIDSA), Centro Empresas 28760 Tres Cantos (ES)
(72) Inventor: INSENSER FARRE, José Maria, E-28760 Tres Cantos (ES); FAURA ENRIQUEZ, Julio, E-28760 Tres Cantos (ES)
(74) Representative: Urizar Anasagasti, José Antonio
(86) International application number: PCT/ES96/00253
(87) International publication number: WO 98/15976

(57) **Abstract**

Process for the prototyping of mixed signal applications and field programmable system on a chip for the application of said process, to be used independently in relation to a associated hardware in order to enable the user to specify, simulate, emulate and project a complete design and its prototyping, said function being integrated in a unique design setting, said process also comprising the schematic capture and simulation of mixed signals , the reading and writing of the configuration, the examination in real time of any point within the digital blocks or the analog subsystems which are part of said associated hardware, the change of data in real time within some programmable digital cells of said associated hardware, the configuration and reconfiguration of said programmable digital cells, the interaction with the associated hardware, the execution of general purpose user programs, the storage of configuration context throughout the circuit with a microprocessor control and the delivery of data to an application specific integrated circuit (ASIC) using an ASIC library. The system comprises a microprocessor (2), at least one digital macro cell (3), a RAM memory (1), some analog cells (4) and interfaces (5,6,7,8) for the conection of said cells.

## Description

### Object of the invention

The object of the present invention consists of a process for the prototyping of mixed signal applications and a field programmable system on a chip for the application of said process, independently usable and adaptable to different analogue and/or digital hardware applications and capable to provide a direct interface between hardware and software. This process shows important advantages over the systems currently used for this purpose.

There is a big number of applications based on dynamic reconfiguration that could be identified and implemented with the digital hardware system of the present invention. These include communication switches, parallel processing applications as image processing, array-based applications, etc.

### Background of the invention

As the complexity of electronic systems grows, it becomes more difficult to follow a traditional design methodology of working separately on different subsystems with different design and prototyping tools. System designers have been searching for flexible prototyping systems onto which they could map large designs to validate them before manufacture, but only microprocessor emulators and digital configurable arrays have been available in the past. As a consequence of this need, analogue programmable arrays have appeared recently, confirming the interest that the industry shows for field-programmable devices suitable for fast prototyping for market applications.

Currently mixed-signal applications are typically solved in three domains: digital hardware, analogue hardware, and microprocessor programs. It is normal for a medium complexity mixed signal integrated circuit to include a microprocessor core to run a user program, some digital hardware for control purposes and an analogue subsystem for data acquisition or analogue applications. In such case, the typical designer normally follows a discrete methodology: an assembler-compiler-debugger for the microprocessor program, a design entry tool (either schematic capture or HDL) and a digital simulator for the digital hardware, and an analogue simulator for the analogue subsystem. The main problem for users of this methodology is that the design is conceived and designed separately and it turns out to be difficult to control the interfaces between these three domains. The situation is also not very promising about prototyping: the best solution normally is to use a field programmable gate array (FPGA) for the digital hardware, some discrete Integrated Circuits or, recently, an analogue array for the analogue hardware, and a microprocessor emulator for the user program. Again, a completely different development system has to be used for each part, and special care has to be taken when designing the different interfaces.

With the purpose to prevent the deficiencies presented by the processes for prototyping mixed signal applications currently in the market, it has been developed a new process for prototyping mixed signal applications and field programmable system on a chip for the application of said process, the object of the present invention.

### Description of the Invention

In this context it is introduced the process for prototyping mixed signal applications and field programmable system on a chip for the application of this process, the aim of the current invention, that is a new concept for system prototyping and programmable hardware. This system consists of a mixed-signal field programmable device (FPD) with a standard microprocessor core, a suitable set of Computer Aided Design tools (CAD tools) to easily program it, and a set of library macros and cells which support a number of typical applications to be easily mapped onto the Field Programmable Gate Array and migrated to an ASIC afterwards, if required.

In particular the field programmable system on chip for the application of the process for the prototyping of mixed signal applications includes, preferably, a microprocessor block, integrated storage media for writing and reading as, preferably, a RAM memory, at least one digital programmable macro cell, analogue cells and connection interfaces of the digital and analogue cells.

The interaction between each of the three domains (digital hardware, analogue hardware and microprocessor programs) is as close as it can be: the microprocessor can read and write the configuration of the analogue and digital hardware can physically interface ports and the entire microprocessor bus can be connected to the routing channels of the Field Programmable Gate Array (FPGA), can examine in real time, any point within the digital blocks or analog subsystems, and can also change data in real time within the flip-flops housed inside digital programmable cells which form on chip the field programmable system. The microprocessor is then used to configurate (and reconfigurate) the programmable cells, to interact with the actual hardware mapped onto them and to run general purpose user programs.

The invention concept relies upon the fully integrated design and prototyping methodology that the user can follow with such a system. A powerful set of user-friendly CAD tools is provided, with the final target of letting the user specify, simulate, emulate (probe) and map the complete design on a single chip using one design environment. This includes mixed-signal schematic capture and simulation, automatic technology mapping, placement and routing tools, an integrated emulation software (which allows step by step program execution and real time internal signal checking), and an integrated device programming package.

A large set of library macros provides optimised solutions to typical design needs, allowing the user to implement his own macros at any design level, from HDL to any manual placement and routing. A parallel ASIC library is also supported to make the migration to ASIC much easier than in normal prototyping solutions.

Finally as an added value, two configuration contexts are stored, which makes it possible to change the configuration of the whole circuit (or part of it) with a microprocessor command. This feature, and the close interaction between the microprocessor and the programmable digital cells, makes this Field Programmable Gate Array (FPGA) a powerful tool for applications based on hardware-software interaction and dynamic reconfiguration.

Therefore two configuration contexts are stored for every programmable feature of the Field Programmable System on chip. In fact, every configuration bit is a dual port 2-bit memory cell.

The microprocessor can then read and write any of these memory locations while in operation. This allows the user to reconfigurate a context while the other one is still active, then changing the active context to the new one. With this approach, the whole circuit can be reconfigurated just by issuing a microprocessor command, and the reconfiguration time would be that of a microprocessor writing cycle. In fact, as long as the microprocessor can reconfigurate any single cell of the FPGA, a set of cells rather than the whole chip can be reconfigurated "on the fly". Furthermore, the data inside the Flip-Flops is also duplicated, and can also be read and written by the microprocessor while the application is running. When the context is swapped, the status of the Flip-Flops can be maintained or stored with the rest of the context. This makes it possible to initialise the Flip-Flops in the non-active context before setting it as active, and also to save the values of the circuit nodes when changing the context.

This technique known as hardware swap, makes it possible to efficiently work with virtual hardware. Non-active contexts keep their configuration and data just like virtual memory that is stored into a swap file in a computer system. A hardware swap takes place when the virtual hardware is mapped back onto the actual hardware resources, just like the information inside the swap archive is restored onto the actual memory of a computer when required again. Moreover, an analogy can be established between virtual hardware and software procedures: global variables in software procedures can be compared to data in the Flip-Flops which are kept after hardware swap, and procedure parameters can be compared to data in the Flip-Flops which are saved and restored during the hardware swap.

In this way, the design procedure can be mapped in a closed flow diagram that have three source vertexes, in a such way that starting from each of these vertex it gets, directly or indirectly, to the simulation and/or real time emulation, the outcome is the integrated waveform representation. These source vertexes correspond to the field programmable system on chip itself, the design is mapped onto the own chip, the HDL design, the functional blocks for integrated source code design. From these vertexes it is possible to access, directly or indirectly, to the simulation blocks or/and the integrated emulation. The indirect ways include blocks that determine the chip or device programing from where the real time integrated emulation is accessed.

The key point of this design flow is that it follows an integrated methodology. This implies integrated design specification, simulation, emulation, waveform display, technology mapping (with placement and routing) and device programming.

From the afore mentioned description it is easy to deduct the advantages provided by the process for prototyping mixed signal applications and field programmable system on a chip for the application of this process. In this way, the integrated methodology can be carried out due to the flexibility of the configurable analogue and digital hardware, and the easy interface between the digital resources, the analogue subsystem and the microprocessor. In the same way, the use of a field Programmable System on a chip in the process for the prototyping of mixed signal applications provides immediate reduction of Printed Circuit Board (PCB) space, device reusability, dynamic reconfigurability and fast delivery to market, what altogether makes the chip more suitable for prototyping, pre-series manufacture and microelectronics research.

### Description of the figures

To better understand the object of the present invention we described hereinafter a practical preferential embodiment of the process for prototyping of mixed signal applications and the field programmable system on a chip for the application of said process, according to the attached figures. These figures show:
1) Figure 1 shows a field programmable system on a chip block diagram.
2) Figure 2 shows digital macro cell block diagram. This cell is included in the device showed in Figure 1.
3) Figure 3 shows a 2 bit double port memory cell for each configuration bit.
4) Figure 4 shows a general view of the process for prototyping mixed signal applications.

### Preferential embodiment of the invention

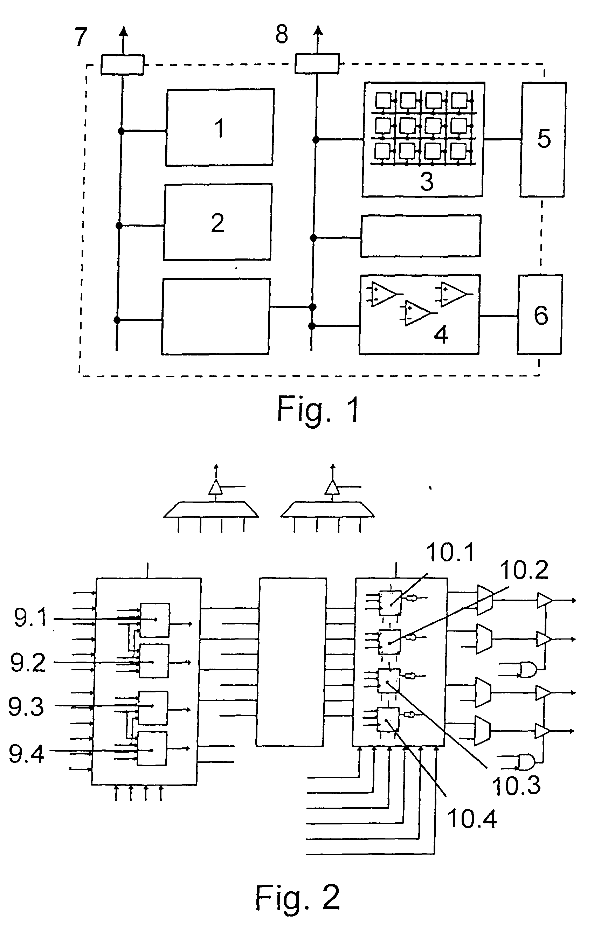

The field programmable system on a chip, object of the present invention includes a RAM memory (1), a microprocessor (2), programmable digital macro cell (3) and programmable analogue cells (4). As it is seen in the Figure 1, the system includes several interfaces (5,6,7,8) needed for the correct system function.The Digital Macro Cell (DMC) is a large granularity, LUT based (9.1, 9.2, 9.3, 9.4), synthesis targeted 4-bit wide programmable cell.

Each searching table (LUT) (9.1, 9.2, 9.3, 9.4) can implement any Boolean function of 4 inputs, and two LUTs can be combined to form a 5 input function. The four LUTs of a DMC can be combined to perform any 6 input Boolean function. Four flip-flops (FF)( 10.1, 10.2, 10.3, 10.4) are available within every Digital Macro Cell (DMC), and each one can be independently configured as mux-type or enable and latch or FF, and with synchronous and asynchronous set or reset. Both parts (combinational and sequential) of the DMC can be used more or less independently. There also is a number of macro modes which can configurate the DMC as a 16x4 memory (in fact, two independent 16x2 memories), a 4 bit adder designed for a cascade arrangement with in and out loading, a displacement recording designed for a cascade arrangement with a predeterminated load value and qualification, and a 4 bit increase or decrease counter designed for a cascade arrangement with a predeterminated load value and qualification. These macro functions are especially suitable for use on synthesis programs

The analogue subsystem(4) is composed of fixed functionality blocks of coarse granularity. The analogue functions include user programmable amplifiers, filters, analogue multiplexers, comparators, voltage references, 10-12 bits Analogue Digital Converters/ Digital Analogue Converters (ADC/DACs,) etc. Several parameters can be configurated from the microprocessor (2), such as the operating frequency of the filters, the gain and offset of the amplifiers, the function of the ADC/DAC block (as a DAC or as an ADC), etc.

An optimised serial link is provided to communicate the microprocessor core with the digital and analogue hardware. The configuration is read and written using this interface, and the actual signals at the outputs of the Digital Macro Cells (3) (DMCs) can be accessed by the microprocessor (2) too. The Analogue to Digital Converter (ADC) can also be triggered using this interface, so it is possible to use it from the microprocessor without wasting configurable hardware resources (DMCs and routing channels) to map the ADC onto the microprocessor address space.

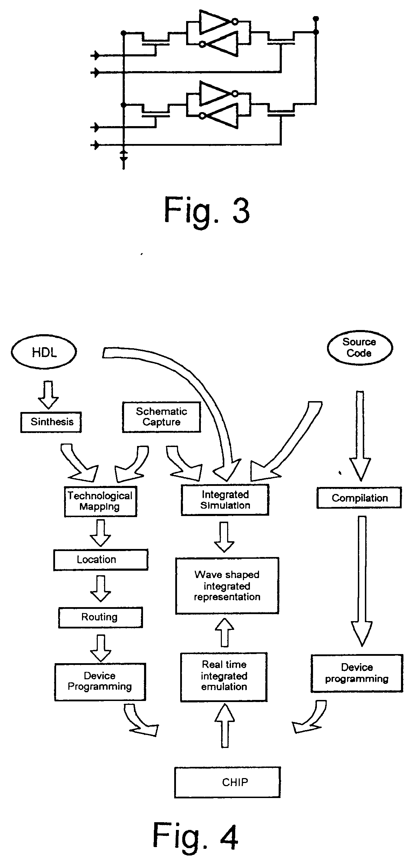

Figure 3 shows a 2 bit double port memory cell for each configuration bit. In this figure it can be seen the flip-flops, these memory locations can be read and written by the microprocessor (2). While one memory is mode active, the other can be reconfigurated later, shifting the latter to active condition.

With this arrangement the design procedure is performed according to the steps shown in figure 4, where a closed flow diagram corresponding to this design procedure is shown. This design procedure includes three source vertexes, in such way that starting out from any of these, it gets, directly or indirectly, to the simulation and or a real time integrated emulation, so the corresponding outcome can be seen in the integrated waveform representation. These source vertexes corresponds to the field programmable system on chip itself, where the design is mapped onto, the HDL design, and an schematic entry tool, that determines a source code design. Form these vertexes it is possible to access, directly or indirectly, to the simulation blocks or/and the integrated emulation. The indirect ways include blocks that determine the chip or device programming from where we have access to real time integrated emulation.

The key for the design procedure is the integrated process. This means that the user can prepare the design specification, the simulation, the emulation, the waveform display, the technology mapping with placement and routing and the device programming in an integrated way.

The user can then connect with the system practically at every point of the design flow. For instance, the user can specify the design in HDL before doing the synthesis, or at gate level before the technology mapping, or work with the digital macro cells (chip) before its placement and routing, or implement a manual placement and routing.

The emulation box allows for the emulation of the microprocessor program including step by step execution, breakpoints, etc., and probing of the internal points of the analogue or digital architecture. This way, the user can check the sequential program correct performance and, at the same time, see the current values of actual nodes of the circuit.

Finally, a simple serial interface to the chip outside can be used to power up the system from a PC, so a complete development system can be implemented using only the Field programmable system on a chip, the Personal Computer (PC) and a RS232 interface for their interconnection.

An integrated waveform display is provided to understand how the entire system is interacting at a given moment on operation time or simulation time. This device includes an analogue waveform display (in fact, when emulation is used this is quite like a digital oscilloscope), a digital waveform display (this is like a logic analyser) and a code execution window (where one can trace the program, set breakpoints, etc.).

Once it has been described the nature of the present invention and one way to implement it, we only have to add that as a whole or in some parts of it it is possible to introduce some changes of shape, materials and arrangement, as long as these modifications do not change in a substantial way, the main characteristics of this invention, which are claimed in the following paragraphs.

## Claims

1. Process for the prototyping of mixed signal applications, usable independently in relation to a associated hardware associated in order to enable the user to specify, simulate, emulate and project a complete design and its prototyping, characterised in that the specification, the simulation, the emulation and the design projected are integrated functions in only one design environment, furthermore this process includes:
- Schematic capture and mixed- signal simulation
- Reading and writing of the configuration of the associated hardware trough a microprocessor.
- To examine in real time every point within the digital blocks or analogue subsystems included in the associated hardware.
- To change data in real time within the programmable digital cells of this associated hardware.
- To configurate and reconfigurate the programmable digital cells.
- To interact with the associated hardware.
- To execute general purpose user programs
- To store the configuration context that make possible the configuration context change in the whole circuit following a microprocessor command.
- To export data to an Application Specific Integrated Circuit (ASIC) using an ASIC library.

2. Process for the prototyping of mixed signal applications, according to claim 1, characterised in that the configuration context change includes the storage of programmable cells status, giving the possibility to initialise the cells in the non active context before to be activated, also to keep the circuit node values during the context change.

3. Field Programmable System on a chip for the application of the process according to calims 1 and 2, characterised in that the system includes:
- One microprocessor (2)
- On chip RAM memory (1)
- At least one digital macro cell (3)
- Analogue cells (4)
- Analogue (4) and digital cells (3) connection Interfaces ( 5,6,7,8)

4. A system according to claim 3, characterised in that the digital macro cell (3) is of big granularity, comprising several LUTs (searching tables) (9.1, 9.2, 9.3, 9.4), to implement boolean functions in an independent way or combined to each other. Every searching table has a 4-bit wide.

5. A system, according to claim 4, characterised in that each digital macro cell (3) includes 4 flip-flops (10.1, 10.2, 10.3, 10.4). Each flip-flop can be configurated in an independent way.
